# EUROPÄISCHE PATENTANMELDUNG

(11) **EP 4 749 858 A2**
(43) Veröffentlichungstag der Anmeldung: **27.05.2026**
(21) Anmeldenummer: 26172174.0
(22) Anmeldetag: 04.10.2023
(51) Int. Cl.: H02H 3/087

(54) **VORRICHTUNG UND VERFAHREN ZUR SICHERHEITSABSCHALTUNG EINES ELEKTRISCHEN VERBRAUCHERS IN EINEM FAHRZEUG**

(30) Priorität: 05.10.2022 EP 22199853
(62) Teilanmeldung aus: 23201584.2
(71) Anmelder: Elmos Semiconductor SE, 51379 Leverkusen (DE)
(72) Erfinder: Sudhaus, Andre, 45665 Recklinghausen (DE); Abaza, Fikret, 57169 Duisburg (DE); Maurer, Peter, 42555 Velbert (DE)
(74) Vertreter: dompatent

(57) **Zusammenfassung**

Bei der Sicherheitsabschaltung eines elektrischen Verbrauchers (14) in einem Fahrzeug wird die Stromaufnahme des Verbrauchers (14) in dessen Aktivzustand durch eine Hauptüberwachungseinheit (41) hinsichtlich einer Sicherheitsabschaltschwelle überwacht, die, wenn sie erreicht oder überschritten wird, zur Erzeugung eines Ausschaltsignals (43) zum Ausschalten des elektronischen Schalters (18) durch die Hauptüberwachungseinheit (41) führt. In einem sich von seinem Aktivzustand unterscheidenden anderen Betriebszustand, in dem die Stromaufnahme der Leitung, die zu dem mindestens einen Verbraucher (14) führt, geringer ist als in seinem Aktivzustand, wird die Stromaufnahme von einer Hilfsüberwachungseinheit (47) hinsichtlich der Geschwindigkeit von Veränderungen überwacht. Die Hauptüberwachungseinheit (41) wird bei sich in dem weiteren Betriebszustand oder in einem der weiteren Betriebszustände befindenden Verbraucher (14) deaktiviert oder in einem Standby-Modus mit einer gegenüber einer Aktivierung der Hauptüberwachungseinheit (41) reduzierten Funktionalität und Stromaufnahme betrieben. Die Hauptüberwachungseinheit (41) wird bei sich in dem weiteren Betriebszustand oder einem der weiteren Betriebszustände befindenden Verbraucher (14) zur Überwachung der Stromaufnahme des Verbrauchers (14) hinsichtlich des Erreichens oder Überschreitens der Sicherheitsabschaltschwelle aktiviert, wenn die Geschwindigkeit von Veränderungen der Stromaufnahme einen ersten Schwellwert (38) erreicht oder überschreitet und/oder einen ersten Spannungsbereich unter- oder überschreitet.

## Beschreibung

Die vorliegende Erfindung nimmt die Priorität der europäischen Patentanmeldung 22 199 853.7 vom 5. Oktober 2022 in Anspruch, deren Inhalt hiermit durch Bezugnahme zum Gegenstand der vorliegenden Patentanmeldung gehört.

Die Erfindung betrifft eine Vorrichtung und ein Verfahren zur Sicherheitsabschaltung eines elektrischen Verbrauchers in einem Fahrzeug.

Die elektrischen Verbraucher eines Fahrzeugs sind typischerweise gegen zu große Ströme durch Sicherungen abgesichert. Während in früheren Zeiten hierfür Schmelzsicherungen eingesetzt wurden, ist in letzter Zeit zunehmend von Fahrzeugherstellern die Anforderung nach Ersatz der Schmelzsicherungen durch elektronische Schalter, also Transistoren, zu verspüren. Ein Vorteil dieser elektronischen Schalter besteht beispielsweise darin, dass diese Art der Abschaltsicherung auch nach einer Sicherheitsabschaltung des Verbrauchers wieder eingesetzt werden kann und dass sehr viel detailliertere Informationen zum Bordnetz-Zustand des Fahrzeugs, wie z.B. lokale Stromeinflüsse bzw. Knotenspannungen, geliefert werden können. Applikationsabhängig sind weitere Anwendungen elektronischer Schalter als Abschaltsicherheitselemente denkbar.

Bei elektronischen Schaltern für Sicherheitsabschaltvorrichtungen elektrischer Verbraucher in einem Fahrzeug ist es erforderlich, die aktuelle Stromaufnahme des Verbrauchers messtechnisch zu erfassen und zu bewerten, um bei einer potentiellen Strom- oder Spannungsüberlastung den elektronischen Schalter ausschalten zu können. Die hierfür erforderlichen Schaltungen und Schaltungskomponenten benötigen für Ihren Betrieb elektrische Energie.

Zur Reduktion des Energieverbrauchs eines Fahrzeugs ist es bekannt, elektrische Verbraucher, die nicht dauerhaft im Einsatz sind, dann, wenn sie nicht benötigt werden, in einen Ruhe- bzw. Sleep-Zustand oder in einen Standby-Zustand zu überführen. In diesen beiden Betriebszuständen ist die Stromaufnahme des elektrischen Verbrauchers mitunter deutlich geringer als in seinem Aktivzustand.

Wenn sich der elektrische Verbraucher nicht in seinem Aktivzustand befindet, so sollte auch die Sicherheitsabschaltvorrichtung in einem Stromsparmodus arbeiten. Das aber ist mitunter problematisch, da sie in erster Linie für die Überwachung im Aktivzustand des Verbrauchers und damit für eine im Vergleich zum Ruhe- bzw. Standby-Betriebszustand deutlich größere Stromaufnahme im Aktivzustand ausgelegt ist, demzufolge weniger sensitiv für die damit vergleichsweise kleinen Stromaufnahmen im Ruhe- bzw. Standby-Betriebszustand des Verbrauchers ist. Mitunter kann auch der Fall auftreten, dass die elektronische Sicherheitsabschaltvorrichtung ohne stromsparende Maßnahmen im Ruhe- bzw. Standby-Betriebszustand des Verbrauchers mehr Energie als der Verbraucher benötigen könnte.

Aus DE-A-10 2019 125 122 ist es bekannt, einen elektronischen Schalter unter Aufwendung möglichst geringer elektrischer Energie dann zu überwachen, wenn sich ein Verbraucher, der an die mit dem elektronischen Schalter versehenen Leitung angeschlossen ist, im Ruhe- oder Standby-Betriebsmodus befindet.

Aus DE-A-10 2019 202 163 wird eine Schutzvorrichtung zum Abschalten einer Batteriezelle eines Batteriesystems beschrieben, bei der Stromaufnahmeveränderungen Auslöser für das Abschalten der Batteriezelle sind.

Aufgabe der Erfindung ist es, eine Vorrichtung und ein Verfahren zur Sicherheitsabschaltung eines elektrischen Verbrauchers in einem Fahrzeug zu schaffen, wobei die Stromaufnahmeüberwachung in den Betriebszuständen des Verbrauchers, in denen diese eine gegenüber seinem Aktivzustand mitunter deutlich geringere Stromaufnahme aufweist, ebenfalls stromsparend ausgelegt ist.

Zur Lösung dieser Aufgabe wird mit der Erfindung eine Sicherheitsabschaltvorrichtung für einen elektrischen Verbraucher in einem Fahrzeug vorgeschlagen, wobei der Verbraucher in einem Aktivzustand und in mindestens einem weiteren Betriebszustand in einem Ruhezustand mit gegenüber dem Aktivzustand verminderter Stromaufnahme betreibbar ist, mit
- einem einen Strompfad aufweisenden elektronischen Schalter in einer direkt oder indirekt zu dem mindestens einen Verbraucher des Fahrzeugs führenden Versorgungsleitung angeordnet ist, über die der Verbraucher mit den für den Betrieb in seinem Aktivzustand und für den Betrieb in seinem mindestens einen weiteren Betriebszustand oder in einem seiner weiteren Betriebszustände jeweils erforderlichen Ströme und Spannungen versorgbar ist,
- einer Treiberschaltung zur Ansteuerung des elektronischen Schalters, wobei an die Treiberschaltung entweder ein Einschaltsignal zum Einschalten des elektronischen Schalters und damit zum Leitendschalten seines Strompfads oder ein Ausschaltsignal zum Ausschalten des elektronischen Schalters und damit zum Sperrendschalten seines Strompfads anlegbar ist,
- einem zur Anordnung in der Versorgungsleitung vorgesehenen und bei einem Stromfluss durch die Versorgungsleitung einen Spannungsabfall erzeugenden Spannungserfassungsmittel,
- mindestens einem Spannungsverstärker mit zwei Eingängen, die beidseitig des Spannungserfassungsmittels mit diesem oder mit der Versorgungsleitung verbunden sind, und mit einem ein verstärktes Signal liefernden Ausgang,
- einem Hoch- oder Bandpassfilter zur Filterung des Signals am Ausgang des Spannungsverstärkers mit einem mit dem Ausgang des Spannungsverstärkers verbundenen Eingang und mit einem das gefilterte Signal liefernden Ausgang,
- einem mit dem Ausgang des Hoch- oder Bandpassfilters verbundenen, zwei Eingänge und einen Ausgang aufweisenden, ersten Komparator zum Vergleichen der Größe des Ausgangssignals des Hoch- oder Bandpassfilters mit einem ersten Schwellwert und/oder mit einem ersten Spannungsbereich,
- wobei der erste Komparator an seinem Ausgang ein erstes Aktivierungssignal ausgibt, wenn das Ausgangssignal des Hoch- oder Bandpassfilters größer als der erste Schwellwert oder gleich dem ersten Schwellwert ist und/oder den ersten Spannungsbereich unter- oder überschreitet,
- einer mit dem Ausgang des ersten Komparators verbundenen Überwachungseinheit, die immer dann, wenn sich der mindestens eine Verbraucher in seinem Aktivzustand oder in seinem mindestens einen weiteren Betriebszustand oder in einem seiner weiteren Betriebszustände befindet, für die Treiberschaltung das Einschaltsignal für den elektronischen Schalter zur Versorgung des mindestens einen Verbrauchers mit Strom und zwecks einer potenziellen Sicherheitsabschaltung des mindestens einen Verbrauchers für die Treiberschaltung das Ausschaltsignal für den elektronischen Schalter ausgibt,
- wobei die Überwachungseinheit umschaltbare Schaltungskomponenten aufweist, die wahlweise aktivierbar oder deaktivierbar, d.h. in einen Ausschalt- oder einen Standby-Modus überführbar sind, wie z.B. eine Logikschaltung, einen ADC für eine Spannungsabfallmessung mit z.B. Bestimmung der thermischen Belastung der Versorgungsleitung und/oder des mindestens einen Verbrauchers auf Grund einer erhöhten Stromaufnahme und/oder eine Temperaturkompensationsschaltung und/oder eine Spannungsversorgungs- und/oder Spannungsregelschaltung und/oder Komparatoren mit Referenzspannungserzeugungsschaltungen,
- wobei die Überwachungseinheit dann, wenn ihre umschaltbaren Schaltungskomponenten deaktiviert sind, eine geringere elektrische Energie benötigt als in dem Fall, in dem ihre umschaltbaren Schaltungskomponenten aktiviert sind, und
- wobei die umschaltbaren Schaltungskomponenten der Überwachungseinheit dann, wenn sie deaktiviert sind, bei Empfang des am Ausgang des ersten Komparators anstehenden ersten Aktivierungssignals aktivierbar sind.

Vorteilhafte Ausgestaltungen der Erfindung sind Gegenstand der abhängigen Vorrichtungsansprüche.

Die erfindungsgemäße Sicherheitsabschaltvorrichtung weist einen elektronischen Schalter mit einem Strompfad auf. Der elektronische Schalter ist zur Anordnung in einer Versorgungsleitung vorgesehen oder ist in einer Versorgungsleitung angeordnet, die direkt oder indirekt zu dem (mindestens einen zu schützenden) Verbraucher des Fahrzeugs führt. Der Strompfad des elektronischen Schalters, bei dem es sich typischerweise um einen Transistor und insbesondere um einen MOS-Transistor o.dgl. Feldeffekttransistor handelt, wird durch ein Einschaltsignal eingeschaltet, also leitend geschaltet, und durch ein Ausschaltsignal ausgeschaltet, d. h. also sperrend geschaltet, die eine den elektronischen Schalter ansteuernde Treiberschaltung empfängt.

In der Versorgungsleitung befindet sich ferner ein Spannungserfassungsmittel zur Erzeugung eines Spannungsabfalls bei einem Stromfluss durch die Versorgungsleitung. Der Spannungsabfall über dem Spannungserfassungsmittel, das erfindungsgemäß also zur Anordnung in der besagten Versorgungsleitung vorgesehen ist, wird mittels eines Spannungsverstärkers verstärkt, der an seinem Ausgang das verstärkte (Spannungsabfall-)Signal liefert. Das Ausgangssignal des Spannungsverstärkers oder aber auch das (unverstärkte) Spannungsabfallsignal wird einer Überwachungseinheit zugeführt, die beispielsweise die Größe des Signals überprüft, um im Notfall ein Ausschaltsignal für den elektronischen Schalter zu erzeugen. Die Funktionalität der Überwachungseinheit ist z.B. dann gegeben, wenn sich der elektrische Verbraucher in seinem Aktivzustand befindet. Ist hingegen der elektrische Verbraucher in seinem Ruhe- bzw. Standby-Betriebszustand, so kann die Überwachungseinheit erfindungsgemäß deaktiviert bzw. hinsichtlich ihrer Funktionalität deutlich eingeschränkt sein, um den Bedarf an elektrischer Energie bei der Überwachung der Stromaufnahme des elektrischen Verbrauchers in dessen Ruhe- bzw. Standby-Betriebszustand zu reduzieren. Insoweit kann also die Überwachungseinheit von ihrem Aktiv-Modus, in dem sie die vollständige Sicherheitsüberwachung des oder der Verbraucher übernimmt, in einen Standby-Modus (oder gar nahezu Ausschalt-Modus), in dem die Versorgung mit Energie reduziert, insbesondere deutlich reduziert ist, und umgekehrt überführt werden. Im Vorherigen und im Folgenden ist somit mit "deaktiv" oder "deaktiviert", bezogen auf die Überwachungseinheit, also deren Standby- bzw. Ausschalt-Modus gemeint, in dem die Überwachungseinheit z.B. durch Signale, intern gespeicherte Zustände, durch das Ausbleiben von Taktsignalen oder durch die Änderung der bzw. durch die Trennung von der Versorgungsspannung mit niedriger Stromaufnahme, möglichst mit Stromaufnahme gegen Null, betrieben wird.

In welchem Zustand sich der Verbraucher oder die Verbraucher, zu der die Versorgungsleitung mit dem elektrischen Schalter und dem Spannungserfassungsmittel führt bzw. führen, befindet bzw. befinden, wird der Überwachungseinheit typischerweise von einer übergeordneten Systemebene gemeldet, kann aber auch direkt durch den oder die Verbraucher erfolgen.

Erfindungsgemäß wird nun die Stromaufnahme des elektrischen Verbrauchers vor allem dann, wenn er sich in seinem Ruhe- bzw. Standby-Betriebszustand befindet, hinsichtlich der dynamischen Veränderungen ihrer Amplitude/Größe überwacht. Eine derartige Überwachung des Verbrauchers durch die im deaktivierten Zustand der Überwachungseinheit kann aber ebenso auch bei im Aktivzustand befindlichem Verbraucher durchgeführt werden, wenn auch vorteilhafterweise lediglich kurzzeitig. In beiden Fällen wird die Geschwindigkeit, mit der derartige Änderungen stattfinden, bewertet. DC-Anteile sowie Offset-Einflüsse und vergleichsweise "träge" temperaturbedingte Einflüsse auf das Ausgangssignal des Spannungsverstärkers spielen hier keine Rolle. Es werden ausschließlich demgegenüber höherfrequente Veränderungen des Ausgangssignals des Spannungsverstärkers berücksichtigt, da solche Veränderungen typische Anzeichen für einen Wechsel des Lastzustandes des Verbrauchers oder für das Auftreten von Kurzschlüssen sein können. Hierzu wird das Ausgangssignal des Spannungsverstärkers einem Hoch- oder Bandpassfilter zugeführt. Das Ausgangssignal dieses Filters wird erfindungsgemäß in einem (ersten) Komparator mit einem ersten Schwellwert verglichen. Erreicht das Ausgangssignal des Hoch- oder Bandpassfilters diesen ersten Schwellwert oder übersteigt es ihn, so erzeugt der Komparator ein (erstes) Aktivierungssignal, das der Überwachungseinheit zugeführt wird, woraufhin die Überwachungseinheit aus ihrem bis dahin eingenommenen Standby-Modus in ihren Überwachungsmodus zur Entfaltung ihrer vollständigen Funktionalität überführt wird. Das Aktivierungssignal dient also sozusagen dem "Aufwecken" der Überwachungseinheit. Die insoweit von "deaktiv" auf "aktiv" umschaltbaren Schaltungskomponenten wie z.B. eine Logikschaltung, einen ADC für eine Spannungsabfallmessung mit z.B. Bestimmung der thermischen Belastung der Versorgungsleitung und/oder des mindestens einen Verbrauchers auf Grund einer erhöhten Stromaufnahme und/oder eine Temperaturkompensationsschaltung und/oder eine Spannungsversorgungs-und/oder Spannungsregelschaltung und/oder Komparatoren mit Referenzspannungserzeugungsschaltungen, werden also nun "aufgeweckt", so dass die Überwachungseinheit so betrieben wird, dass ihre Schaltungskomponenten für eine absolute oder über die Zeit integrative Bewertung von Strömen und/oder elektrischen Leistungen und/oder Spannungen auf einer Leitung sorgen, was grundsätzlich bei elektronischen Sicherungen, die einen aktiven Verbraucher vor z.B. einer Überstromaufnahme absichern sollen, bekannt ist. Für das Wesen der Erfindung allerdings ist nur die Deaktivierung dieser Schaltungskomponenten in Zeiten relevant, in denen derartige Bewertungen wegen eines sowieso geringen Strombedarfs des Verbrauchers, wie dies in dessen Ruhe- oder Standby-Betriebszustand beispielsweise der Fall ist, nicht erforderlich sind, um die Schaltungskomponenten in einem potentiellen Bedarfsfalle aktivieren zu können. Der Verbraucher kann sich während dieses "Aufweckprozesses" immer noch in seinem Standby- oder Ruhezustand befinden.

Das Erreichen oder Überschreiten des ersten Schwellwerts des ersten Komparators wird als Anzeichen dafür gewertet, dass der elektrische Verbraucher z.B. in seinen Aktivzustand gewechselt sein könnte. In diesem Zustand sind die Anforderungen an die Stromaufnahmeüberwachung des elektrischen Verbrauchers zwecks einer potenziellen Sicherheitsabschaltung wesentlich höher als in dem Fall, in dem sich der Verbraucher in seinem Ruhe- bzw. Standby-Betriebszustand befindet. Inwieweit die insoweit "aufgeweckte" Überwachungseinheit in diesem Zustand verbleibt, kann durch andere ggf. übergeordnete Überprüfungen des Zustandes des elektrischen Verbrauchers beeinflusst sein. Wenn also erkannt wird, dass sich der elektrische Verbraucher weiterhin im Ruhe- bzw. Standby-Betriebszustand befindet, so könnte die Überwachungseinheit nach einer gewissen Zeit wieder in ihren Betrieb mit verringerter Stromaufnahme (Standby-Modus) zurücküberführt werden, was durch ein übergeordnetes System gesteuert wird oder gemäß einer Zeitbedingung o.dgl. Zustandsbedingung gesteuert durch die Überwachungseinheit selbst erfolgt. So könnte die Überwachungseinheit zeitgesteuert oder gemäß einer anderen Zustandsbedingung "aufwachen", um dann, wenn für eine vorgebbare Zeit von z.B. 0,1 sec, 1 sec oder auch bis zu 10 sec keine erhöhte Stromaufnahme zum Verbraucher registriert wird (z.B. gemäß vorgebbarer Kriterien wie beispielsweise dem gemittelten Strom, dem Stromverlauf oder dem Stromprofil) wieder ihren vorherigen Zustand geringer Stromaufnahme einzunehmen.

Alternativ kann die Überwachungseinheit durch beispielsweise eine Zeitbedingung zyklisch aufgeweckt werden. Weitere Weckbedingungen können an äußere Umstände anknüpfen. Auch diese äußeren Umstände könnten dazu führen, dass die Überwachungseinheit immer wieder von Zeit zu Zeit zyklisch aufgeweckt wird. Dies dient der Überprüfung der ordnungsgemäßen Funktionalität der Überwachungseinheit. Auch kann als Weckbedingung ein etwaiger Spannungseinbruch in dem Fahrzeug-Bordnetz dienen.

Die zuvor beschriebene Steuerung der erfindungsgemäßen Vorrichtung kann vorkonfiguriert in einem Konfigurationsspeicher z.B. der Überwachungseinheit abgelegt sein. Insbesondere dann, wenn der elektronische Schalter aufgrund eines Überstroms zur Sicherung des Verbrauchers ausgestaltet wird, sorgt das übergeordnete System dafür, dass die Überwachungseinheit zeitbedingt oder aufgrund anderer Vorgaben den elektronischen Schalter wieder einschaltet, was z.B. erfolgen kann, wenn der aufgrund des ausgeschalteten elektronischen Schalters ebenfalls ausgeschaltete Verbraucher wieder eingeschaltet wird, also seinen Aktivzustand oder aber seinen Standby- bzw. Ruhezustand einnimmt.

Ein Vorteil der Erfindung ist also darin zu sehen, dass die erforderliche elektrische Energie für die Stromaufnahmeüberwachung im Ruhe- bzw. Standby-Betriebszustand des elektrischen Verbrauchers ebenfalls reduziert ist. Ein weiterer Vorteil der Erfindung ist aber vor allem in der Art und Weise der Bewertung des Spannungsabfalls über dem Spannungserfassungsmittel bei sich im Ruhe- bzw. Standby-Betriebszustand befindlichem Verbraucher zu sehen. In diesem Betriebszustand wird nämlich die Amplitude der insoweit relevanten dynamischen Veränderungen des gemessenen und verstärkten Spannungsabfalls über dem Spannungserfassungsmittel beurteilt. DC-Anteile wie z.B. statische Fehlerbeiträge spielen also keine Rolle. Vorteilhafterweise adaptiert sich diese Art der Überwachung beim Übergang in den Standby-Zustand automatisch an die aktuelle Stromaufnahme als Referenz. Mit anderen Worten spielt es also keine Rolle, wie groß die Stromaufnahme im Ruhe- bzw. Standby-Betriebszustand des elektrischen Verbrauchers tatsächlich ist für verschieden große (Ruhe-)Ströme. Man benötigt also diesbezüglich keinerlei Informationen, so dass man die Überwachung nicht etwa für verschieden große Ströme von elektrischen Verbrauchern in deren Ruhe- bzw. Standby-Betriebszuständen auslegen bzw. vorab definieren muss.

Bei einer Weiterbildung der Erfindung kann der erste Komparator auch die Einhaltung oder Über- bzw. Unterschreitung eines Spannungsbereichs prüfen, wozu er dann als eine Art Fensterdiskriminator ausgebildet ist. Damit wäre es möglich, beide Polaritäten dynamischer Veränderungen sowie die Über- bzw. Unterschreitung von Bereichsgrenzen zu überprüfen. Somit könnte man beispielsweise rückwärts fließende Ströme erkennen, die bei Kurzschlüssen zu anderen Spannungsversorgungsquellen bzw. zu anderen Verbrauchern auftreten könnten. Auch könnte man ein "Öffnen" der Last bzw. des Verbrauchers erkennbar machen, wenn beispielsweise die Stromaufnahme schlagartig von einem DC-Pegel auf Null abfällt.

In vorteilhafter Weiterbildung der Erfindung kann die Sicherheitsabschaltvorrichtung einen mit dem Ausgang des mindestens einen Spannungsverstärkers verbundenen Notabschaltkomparator zum Vergleichen der absoluten Größe des Signals (inklusive DC-Anteilen) am Ausgang des mindestens einen Spannungsverstärkers mit einem Notabschaltschwellwert aufweisen, wobei der Notabschaltkomparator ein Ausschaltsignal für den elektronischen Schalter erzeugt, wenn die Größe des Signals am Ausgang des mindestens einen Spannungsverstärkers den Notabschaltschwellwert erreicht oder überschreitet. Die Maßnahme gemäß dieser Weiterbildung der Erfindung dient einer zusätzlichen Sicherheit für die Abschaltung des elektrischen Verbrauchers im Notfall. Sollten sich nämlich aus welchen Gründen auch immer im Ruhe- bzw. Standby-Betriebszustand des Verbrauchers zu große Ströme einstellen, die vergleichsweise langsam ansteigen, so kann durch den Notschaltkomparator ein Ausschaltsignal für den elektrischen Schalter erzeugt werden. Dies geschieht dann, wenn die Stromaufnahme des elektrischen Verbrauchers die Notabschaltschwelle überschreitet. Relevant in diesem Zusammenhang ist, dass die Reaktionszeit für die Notabschaltung kürzer ist als die zuvor beschriebene Aufweck- bzw. Initialisierungsdauer der Überwachungseinheit. Die Notabschaltschwelle kann verbraucherabhängig eingestellt werden oder einer Schwelle entsprechen, die auch im Aktivzustand des Verbrauchers zur Notfallabschaltung dient. Die Nenn-Stromaufnahme des elektrischen Verbrauchers in dessen Aktivzustand ist typischerweise bekannt. Man sollte dann also die Notabschaltschwelle um einen bestimmten prozentualen Wert höher ansetzen. Das kann beispielsweise automatisch erfolgen, indem die Stromaufnahme des elektrischen Verbrauchers beim Übergang vom Aktivzustand in seinen Ruhe- bzw. Standby-Betriebszustand erfasst und als Grundlage für die Größe der Notabschaltschwelle verwendet wird.

Bei der Sicherheitsabschaltvorrichtung nach der Erfindung kann vorteilhafterweise ferner vorgesehen sein, dass die Überwachungseinheit mit dem Ausgang des mindestens einen Spannungsverstärkers verbunden ist und dann, wenn ihre umschaltbaren Schaltungskomponenten aktiviert sind, das Signal am Ausgang des mindestens einen Spannungsverstärkers hinsichtlich der wahlweisen Erzeugung des Einschaltsignals und des Ausschaltsignals für den elektronischen Schalter bewertet. Diese Verbindung zwischen dem Ausgang des Spannungsverstärkers mit der Überwachungseinheit wird genutzt, wenn die Überwachungseinheit nach Empfang des ersten Aktivierungssignals ihre volle Funktionalität und damit den Überwachungsmodus eingenommen hat. Dann nämlich arbeitet die Überwachungseinheit auf Basis der Größe des Ausgangssignals des Spannungsverstärkers; die Frequenzen und die Größe, d.h. die Amplitude von dynamischen Veränderungen dieses Ausgangssignals spielen dann grundsätzlich erfindungsgemäß keine Rolle mehr.

In weiterer vorteilhafter Ausgestaltung der Erfindung kann vorgesehen sein, dass der Ausgang des Hoch- oder Bandpassfilters mit einem zweiten Komparator zum Vergleichen der Größe des Ausgangssignals des Hoch- oder Bandpassfilters mit einem gegenüber dem ersten Schwellwert größeren zweiten Schwellwert verbunden ist, wobei der zweite Komparator ein zweites Aktivierungssignal ausgibt, wenn das Signal am Ausgang des Hoch- oder Bandpassfilters größer als der zweite Schwellwert oder gleich dem zweiten Schwellwert ist, wobei das zweite Aktivierungssignal der Überwachungseinheit zur Aktivierung ihrer umschaltbaren Schaltungskomponenten zwecks weiterer Be- und Verarbeitung zur eventuellen Umsetzung in ein Ausschaltsignal für den elektronischen Schalter zuführbar und/oder als Ausschaltsignal für den elektronischen Schalter ausgebildet ist. Hierbei wird also das Ausgangssignal des Hoch- bzw. Bandpassfilters mit einem zweiten Schwellwert verglichen, der größer ist als der erste Schwellwert. Sollte also die Geschwindigkeit der Veränderung (d.h. die Amplitude der dynamischen Veränderungen) der Stromaufnahme des elektrischen Verbrauchers im Ruhe- bzw. Standby-Betriebszustand sehr hoch sein, kann dies auf einen Kurzschluss oder einen anderen Gefahrenzustand hindeuten. Das wird dann durch ggf. Ausschalten des elektronischen Schalters abgefangen.

Der zuvor beschriebene Notabschaltkomparator und der gemäß dem zuvor beschriebenen Ausführungsbeispiel der Erfindung vorgesehene zweite Komparator könnte also durchaus zu dem gleichen Ergebnis führen, nämlich dem Ausschalten des elektronischen Schalters. Während dieses Ereignis durch den Notabschaltkomparator aufgrund der Größe des verstärkten Ausgangssignals des Spannungsverstärkers induziert wird, erfolgt es vermittels des zweiten Komparators aufgrund der Dynamik, d. h. der Schnelligkeit der Stromaufnahmeveränderung des elektrischen Verbrauchers in dessen Ruhe- bzw. Standby-Betriebszustand.

In weiterer zweckmäßiger Ausgestaltung der Erfindung kann ein einziger Spannungsverstärker vorgesehen sein, der zwischen einem Betrieb mit höherem Energiebedarf und einem Betrieb mit niedrigerem Energiebedarf umschaltbar ist, also der beispielsweise für den Betrieb bei sich im Aktivzustand und bei sich in seinem mindestens einen weiteren Betriebszustand oder bei sich in einem seiner weiteren Betriebszustände befindenden mindestens einen Verbraucher umschaltbar ist. Die Umschaltung erfolgt durch die Überwachungseinheit gesteuert. Auch der Spannungsverstärker kann also umschaltbar ausgeführt sein, um die Anforderungen an die Genauigkeit der Spannungsverstärkung und der Empfindlichkeit des Spannungsverstärkers daran anzupassen, ob sich die Überwachungseinheit im Überwachungsmodus oder im Standby-Modus befindet bzw. ob sich der elektrische Verbraucher in seinem Aktivzustand oder in einem seiner anderen Betriebszustände mit verringerter Stromaufnahme befindet. So könnte z.B. im Standby-Modus der Überwachungseinheit der Verstärkungsfaktor geändert, und zwar typischerweise vergrößert werden, und/oder die Bandbreite des Spannungsverstärkers auf ein Maß reduziert werden, welches sich an der Bandbreite des Hoch- oder Bandpassfilters orientiert und damit in der Regel weniger schnell ist als im potentiell sicherheitsrelevanten Aktivbetrieb des Verbrauchers. Vorteilhafterweise würde eine DC-Entkopplung Anforderungen an die Genauigkeit der Spannungsverstärkung reduzieren. Da im Fahrzeug im Fahrbetrieb oft höhere Sicherheitslevel gefordert sind als im Abschaltbetrieb oder Standby-Betrieb, kann es auch erlaubte Abstriche beim Level von Sicherheitsüberprüfungen geben.

Gemäß einer vorteilhaften Ausgestaltung der Erfindung kann die Sicherheitsabschaltvorrichtung einen einzigen Spannungsverstärker aufweisen wobei entweder der Spannungsverstärker einen z.B. durch die Überwachungseinheit gesteuerten, veränderbaren Verstärkungsfaktor aufweist, der bei deaktivierten Schaltungskomponenten der Überwachungseinheit größer ist als bei aktivierten Schaltungskomponenten der Überwachungseinheit, oder das Hoch- oder Bandpassfilter einen bei deaktivierten Schaltungskomponenten der Überwachungseinheit zuschaltbaren Spannungsverstärker zur Ausgabe eines gegenüber der Verstärkung durch den Spannungsverstärker noch weiter und damit höher verstärkten Ausgangssignals aufweist.

Alternativ zu dem zuvor Gesagten können ein erster Spannungsverstärker und ein zweiter Spannungsverstärker vorgesehen sein, von denen der erste Spannungsverstärker bei deaktivierten Spannungskomponenten der Überwachungseinheit, also beispielsweise bei sich in seinem mindestens einen weiteren Betriebszustand oder bei sich in einem seiner weiteren Betriebszustände befindenden mindestens einen Verbraucher oder, anders ausgedrückt bei sich im Standby-Modus befindlicher Überwachungseinheit betreibbar und der zweite Spannungsverstärker bei aktivierten Schaltungskomponenten der Überwachungseinheit (also in deren Überwachungsmodus) und somit beispielsweise bei sich im Aktivzustand befindenden mindestens einen Verbraucher betreibbar ist, wobei das Hoch- oder Bandpassfilter mit dem Ausgang des ersten Spannungsverstärkers verbunden ist. Der erste Spannungsverstärker sollte also eine bessere Eignung für die Verarbeitung von geringen Spannungsabfällen über dem Spannungserfassungsmittel z.B. im Ruhe- oder Standby-Betriebszustand des Verbrauchers aufweisen, und zwar unter Akzeptanz einer geringeren Bandbreite, Genauigkeit und Sicherheitsüberwachungsprüfung usw.

In vorteilhafter Ausgestaltung dieser weiteren Alternative der Erfindung kann vorgesehen sein, dass ein erster Spannungsverstärker mit einem ersten Verstärkungsfaktor und ein zweiter Spannungsverstärker mit einem gegenüber dem ersten Verstärkungsfaktor kleineren zweiten Verstärkungsfaktor vorgesehen sind, von denen der erste Spannungsverstärker bei deaktivierten Schaltungskomponenten der Überwachungseinheit betreibbar und der zweite Spannungsverstärker bei aktivierten Schaltungskomponenten der Überwachungseinheit betreibbar ist, und dass das Hoch- oder Bandpassfilter mit dem Ausgang des ersten Spannungsverstärkers verbunden ist.

Wie bereits oben erwähnt, befindet sich in der Versorgungsleitung ein Spannungserfassungsmittel. Hierbei kann es sich um einen Shunt-Widerstand oder bevorzugt um den Strompfad des elektronischen Schalters handeln. Der Strompfad des elektronischen Schalters weist im Einschaltzustand einen äußerst geringen Widerstand auf, was im Übrigen hinsichtlich der Minimierung von Verlustleistungen gewünscht ist. Auch der alternativ zusätzlich zum elektronischen Schalter vorgesehene Shunt-Widerstand sollte vergleichsweise klein sein. In beiden Fällen sind also die Anforderungen an den Spannungsverstärker insbesondere dann, wenn der Verbraucher eine reduzierte Stromaufnahme aufweist, erhöht. Fließt hingegen, wie im Aktivzustand des Verbrauchers typischerweise gegeben, ein vergleichsweise großer Strom, so ist auch der Spannungsabfall vergleichsweise groß, so dass dessen Bewertung hinsichtlich einer potentiellen Sicherheitsabschaltung des Verbrauchers im Aktivzustand unkritischer ist als in dem Fall, in dem sich der Verbraucher im Ruhe- bzw. Standby-Betriebszustand befindet.

Die oben genannte Aufgabe wird erfindungsgemäß auch gelöst durch ein Verfahren zur Sicherheitsabschaltung eines elektrischen Verbrauchers in einem Fahrzeug, der direkt oder indirekt an einen mit einem elektronischen Schalter versehene Versorgungsleitung angeschlossen ist, wobei bei dem Verfahren
- durch eine Hauptüberwachungseinheit, deren Betrieb von einem Überwachungsmodus auf einen Standby-Modus und umgekehrt umschaltbar ist, in ihrem Überwachungsmodus die Stromaufnahme des Verbrauchers hinsichtlich einer Sicherheitsabschaltschwelle überwacht wird, die, wenn sie erreicht oder überschritten wird, zur Erzeugung eines Ausschaltsignals zum Ausschalten des elektronischen Schalters durch die Hauptüberwachungseinheit führt,
   - die Hauptüberwachungseinheit von dem Standby-Modus in den Überwachungsmodus umgeschaltet wird, wenn die Amplitude der dynamischen Veränderungen der Stromaufnahme des Verbrauchers einen ersten Schwellwert (38) erreicht oder überschreitet und/oder einen ersten Wertebereich und/oder einen zum ersten Schwellwert proportionalen Spannungswert oder einem zum ersten Wertebereich proportionalen Spannungsbereich unter- oder überschreitet, und
   - die Stromaufnahme des Verbrauchers in dem Standby-Modus der Hauptüberwachungseinheit von einer Hilfsüberwachungseinheit hinsichtlich der Amplitude einer potentiellen dynamischen Veränderung überwacht wird und die beim Erreichen oder Überschreiten des ersten Schwellwerts und/oder bei Unter- oder Überschreitung des ersten Wertebereichs und/oder des zum ersten Schwellwert proportionalen Spannungswerts oder des zum ersten Wertebereich proportionalen Spannungsbereichs die Umschaltung der Hauptüberwachungseinheit von dem Standby-Modus in den Überwachungsmodus auslöst.

Bei der Hauptüberwachungseinheit handelt es sich um die Überwachungseinheit, die weiter oben im Zusammenhang mit der erfindungsgemäßen Sicherheitsabschaltvorrichtung beschrieben und behandelt worden ist. Die Hilfsüberwachungseinheit weist im Wesentlichen die Merkmale des Hoch- und Bandpassfilters sowie des ersten bzw. des zweiten Komparators auf, die weiter oben im Zusammenhang mit der Sicherheitsabschaltvorrichtung nach der Erfindung beschrieben sind.

In weiterer vorteilhafter Ausgestaltung des erfindungsgemäßen Verfahrens kann vorgesehen sein, dass bei sich im Standby-Modus befindlicher Hauptüberwachungseinheit ein Ausschaltsignal zum Ausschalten des elektronischen Schalters erzeugt wird, wenn die Amplitude der dynamischen Veränderungen der Stromaufnahme des Verbrauchers einen zweiten Schwellwert erreicht oder überschreitet, der größer ist als der erste Schwellwert.

Schließlich kann in einer weiteren vorteilhaften Ausgestaltung des erfindungsgemäßen Verfahrens vorgesehen sein, dass bei sich im Standby-Modus befindlicher Hauptüberwachungseinheit die Größe des Signals eines in der Versorgungsleitung angeordneten Spannungserfassungsmittels mit einem Notabschaltschwellwert verglichen wird, bei dessen Erreichen oder Überschreiten ein Ausschaltsignal zum Ausschalten des elektronischen Schalters erzeugt wird.

Die Auslösung des Übergangs des Betriebs der Überwachungseinheit bzw. Hauptüberwachungseinheit von ihrem Überwachungsmodus auf ihren Standby-Modus kann von extern erfolgen. Ein derartiger Übergang kann z.B. dann oder dadurch ausgelöst werden, wenn der Verbraucher in seinen Ruhe- oder Standby-Betriebszustand überführt wird, was vom aktuellen Fahrbetrieb und den Anforderungen des Fahrbetriebs abhängig sein kann. Andere den besagten Übergang auslösende Momente können aus der Bewertung des Fahrzeugzustandes als Ganzes (Fahrbetrieb, Stand) resultieren. Die einzelnen Ereignisse, die zu einer derartigen Umschaltung des Betriebs der Überwachungseinheit bzw. Hauptüberwachungseinheit führen, sind mannigfaltig und applikationsabhängig und sollen hier nicht weiter vertieft werden, da die Erfindung in erster Linie zum Gegenstand hat, die Überwachungseinheit bzw. Hauptüberwachungseinheit dann, wenn sie weniger Anforderungen erfüllen muss und sich deshalb in einem Standby-Modus befindet, im Bedarfsfalle "aufgeweckt" wird, um prophylaktisch ihre volle Funktionalität zu entfalten.

Die Erfindung wird nachfolgend anhand zweier Ausführungsbeispiele sowie unter Bezugnahme auf die Zeichnung näher erläutert. Im Einzelnen zeigen dabei:
- Fig. 1: ein Blockschaltbild eines ersten Ausführungsbeispiel der Erfindung und
- Fig. 2: ein Blockschaltbild eines zweite Ausführungsbeispiels der Erfindung.

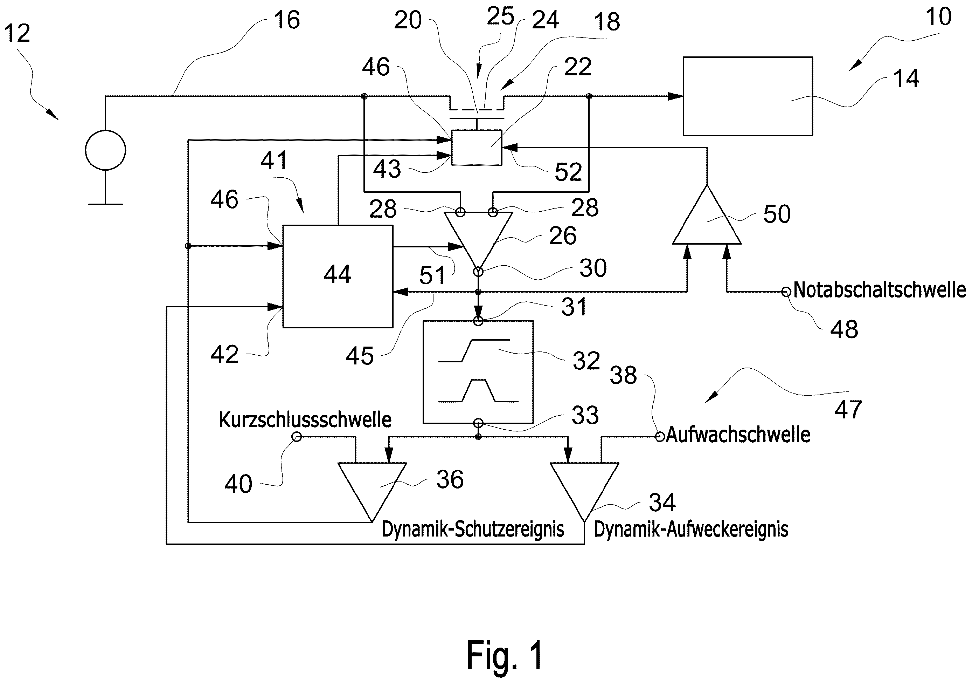

In Fig. 1 ist das Blockschaltbild eines ersten Ausführungsbeispiels einer Sicherheitsabschaltvorrichtung 10 gezeigt. Eine Energiequelle 12, also beispielsweise das Bordnetz eines Fahrzeugs, versorgt einen Verbraucher 14 mit eklektischer Energie. In der zum Verbraucher 14 führenden Versorgungsleitung 16 befindet sich ein elektronischer Schalter 18, in diesem Ausführungsbeispiel in Form eines MOS-Transistors 20, der von einem Treiber 22 angesteuert wird.

Wenn sich der Verbraucher 14 in seinem Ruhe- bzw. Standby-Zustand befindet, ist seine Stromaufnahme gegenüber derjenigen in seinem Aktivzustand deutlich verringert. In diesem Ausführungsbeispiel wird der Strompfad 24 des elektronischen Schalters 18 als Shunt zur Ermittlung eines Spannungsabfalls, d. h. als Spannungserfassungsmittel 25, genutzt. Ein Spannungsverstärker 26 ist mit seinen beiden Eingängen 28 beidseitig des elektronischen Schalters 18 mit der Versorgungsleitung 16 verbunden. Am Ausgang 30 des Spannungsverstärkers 26 liegt dann also das verstärkte Eingangssignal an. Hierbei ist zu beachten, dass das Eingangssignal dann, wenn sich der Verbraucher 14 in seinem Ruhe-oder Standby-Betriebszustand befindet, deutlich kleiner ist als in dem Fall, indem sich der Verbraucher 14 in seinem Aktivzustand befindet. Auf das Ausgangssignal des Spannungsverstärkers 26 wirken sich also Offset- und DC-Einflüsse überproportional aus.

Von Vorteil in diesem Zusammenhang ist, dass für die Stromaufnahmeüberwachung im Ruhe- bzw. Standby-Betriebszustand des Verbrauchers 14 sich die Größe des DC-Anteils des Ausgangssignals des Spannungsverstärkers 26 grundsätzlich nicht auswirkt. Es werden vielmehr die Amplituden von dynamischen Änderungen des Ausgangssignals des Spannungsverstärkers 26 untersucht, um im Bedarfsfalle eine Abschaltung des elektronischen Schalters 18 zu induzieren.

Das Ausgangssignal des Spannungsverstärkers 26 wird dazu dem Eingang 31 eines Hoch- bzw. Bandpassfilters 32 mit einem Ausgang 33 zugeführt. Durch dieses Filter 32 bleiben DC-Anteile des und Offset-Einflüsse auf das verstärkte Ausgangssignal des Spannungsverstärkers 26 unberücksichtigt. Auch vergleichsweise "träge" Spannungsänderungen aufgrund von Temperatureinflüssen oder aufgrund von Alterungseffekten werden sozusagen "weggefiltert". Änderungen des Ausgangssignals des Spannungsverstärkers 26 mit Frequenzen, die oberhalb der Eckfrequenz des Hochpassfilters bzw. der unteren Eckfrequenz des Bandpassfilters liegen, passieren dieses Filter und werden auf das Erreichen bzw. Überschreiten zweier Schwellen, nämlich einer (ersten) Aufwachschwelle 38 und einer gegenüber dieser größeren (zweiten) Kurzschlussschwelle 40 untersucht. Hierzu dienen ein erster Komparator 34 und ein zweiter Komparator 36. Der erste Komparator 34 vergleicht das Signal am Ausgang 33 des Hoch-oder Bandpassfilters 32 mit der Aufwachschwelle 38, während der zweite Komparator 36 das Ausgangssignal des Filters 32 mit der Kurzschlussschwelle 40 vergleicht.

Der erste Komparator 34 gibt ein Aktivierungssignal 42 aus, wenn das Ausgangssignal des Hoch- oder Bandpassfilters 32 die Aufwachschwelle 38 überschreitet. Dieses Aktivierungssignal 42 wird einer Überwachungseinheit 44 zugeführt, die im Aktivzustand des Verbrauchers 14 die Stromüberwachung im Hinblick auf eine potenziell erforderliche Sicherheitsabschaltung übernimmt (Betrieb im Überwachungsmodus). Insoweit kann die Überwachungseinheit 44 auch als Hauptüberwachungseinheit 41 aufgefasst werden. Im Ruhe- bzw. Sleep-Betriebszustand des Verbrauchers 14 befindet sich diese Überwachungseinheit 44 in einem Standby-Modus mit eingeschränkter Funktionalität, wobei in diesem Zustand die von der Überwachungseinheit 44 benötigte elektrische Energie deutlich geringer ist als bei voller Funktionalität. Durch das erste Aktivierungssignal 42 wird also die Überwachungseinheit 44 sozusagen "aufgeweckt".

Nachdem die Überwachungseinheit 44 also aus dem Standby-Modus in den Überwachungsmodus gewechselt hat, könnte sie nun beispielsweise im Bedarfsfalle den Treiber 22 mit einem Ausschaltsignal zum Ausschalten des elektronischen Schalters 18 versorgen. In ihrem Standby-Modus liefert sie an den Treiber 22 zunächst ein Einschaltsignal zum Einschalten und zur Aufrechterhaltung des Einschaltzustandes des elektronischen Schalters 18. Nachdem die Überwachungseinheit 44 das Aktivierungssignal 42 empfangen hat, überprüft sie beispielsweise anhand der Größe des Ausgangssignals des Spannungsverstärkers 26 (siehe die Verbindungsleitung 45) sowie ggf. aufgrund anderer Informationen von übergeordneten anderen Systemkomponenten des Fahrzeugs, ob eine Sicherheitsabschaltung des elektrischen Verbrauchers 14 erforderlich ist. Ggf. gibt sie ein Abschaltsignal 43 an den Treiber 22 aus. Sollten keine weiteren Anzeichen für eine Sicherheitsabschaltung gegeben sein, wird die Überwachungseinheit 44 typischerweise nach einer gewissen Zeit automatisch wieder in ihren Standby-Modus übergehen.

Sollte das Ausgangssignal des Hoch- oder Bandpassfilters 32 größer sein als die Kurzschlussschwelle 40, so wird (neben dem Aktivierungssignal 42) durch den Komparator 36 ein Notausschaltsignal 46 erzeugt, das ebenfalls der Überwachungseinheit 44 als logisches Signal und auch dem Treiber 22 direkt zugeführt werden kann. Damit kann für den Fall, dass sich das Ausgangssignal des Hoch-oder Bandpassfilters 32 in Größenordnungen bewegt, die beispielsweise einen potenziellen Kurzschluss des elektrischen Verbrauchers 14 oder eine andere Gefahrensituation signalisieren, eine Notabschaltung durchgeführt werden.

Wie bereits zuvor beschrieben, beruht die Überwachung der Stromaufnahme des elektrischen Verbrauchers 14 z.B. in dessen Ruhe- bzw. Standby-Betriebsmodus auf einer Beurteilung der Frequenz und Größe, mit der sich das Ausgangssignal des Spannungsverstärkers 26 verändert (Amplitude der dynamischen Veränderungen). Insoweit können das Hoch- oder Bandpassfilter 32, der erste Komparator 34 und der ggf. vorhandene zweite Komparator 36 als Hilfsüberwachungseinheit 47 aufgefasst werden.

Für den Fall, dass das Ausgangssignal, aus welchen Gründen auch immer, langsam ansteigend eine kritische Größe erreicht, bei der ebenfalls der Verdacht besteht, dass eine Gefahrensituation aufgetreten ist, wird das Ausgangssignal des Spannungsverstärkers 26 mit einer Notabschaltschwelle 48 verglichen, und zwar mittels eines Notabschaltkomparators 50. Wenn dieser Notabschaltkomparator 50 anspricht, erzeugt er ein Notausschaltsignal 52, das direkt dem Treiber 22 des elektronischen Schalters 18 zugeführt wird, womit der elektronische Schalter 18 ausgeschaltet wird.

Der Betrieb des Spannungsverstärkers 26 kann je nachdem, in welchem Zustand sich die Sicherheitsabschaltvorrichtung 10 befindet, geändert werden. Im Standby-Modus der Überwachungseinheit 44, also z.B. dann, wenn der elektrische Verbraucher sich im Ruhe- bzw. Standby-Betriebszustand befindet, könnte der Spannungsverstärker 26 sich in einem Stromsparbetrieb befinden, womit eine weitere Reduktion des Energieverbrauchs verbunden sind. Entwickelt die Überwachungseinheit 44 ihre volle Funktionalität, nämlich beispielsweise aufgrund des Empfangs der logischen Aktivierungs- und Notausschaltsignale 42 und 46, so kann sie den Spannungsverstärker 26 "umschalten" (siehe die Selekt-Steuerleitung 51), so dass er nun wesentlich genauer und/oder wesentlich schneller oder, allgemeiner ausgedrückt, mit einer wesentlichen höheren Performance die an seinem Eingang anliegende Spannung verstärkt. Denn dieser insoweit genauere Betrieb des Spannungsverstärkers 26 wird im Folgenden benötigt, da durch das "Aufwecken" der Überwachungseinheit 44 davon auszugehen ist, dass der elektrische Verbraucher 14 beispielsweise selbst in den Aktivzustand übergegangen ist, in dem seine Stromüberwachung wesentlich genauer erfolgen muss als beispielsweise im Ruhe- bzw. Standby-Betriebszustand.

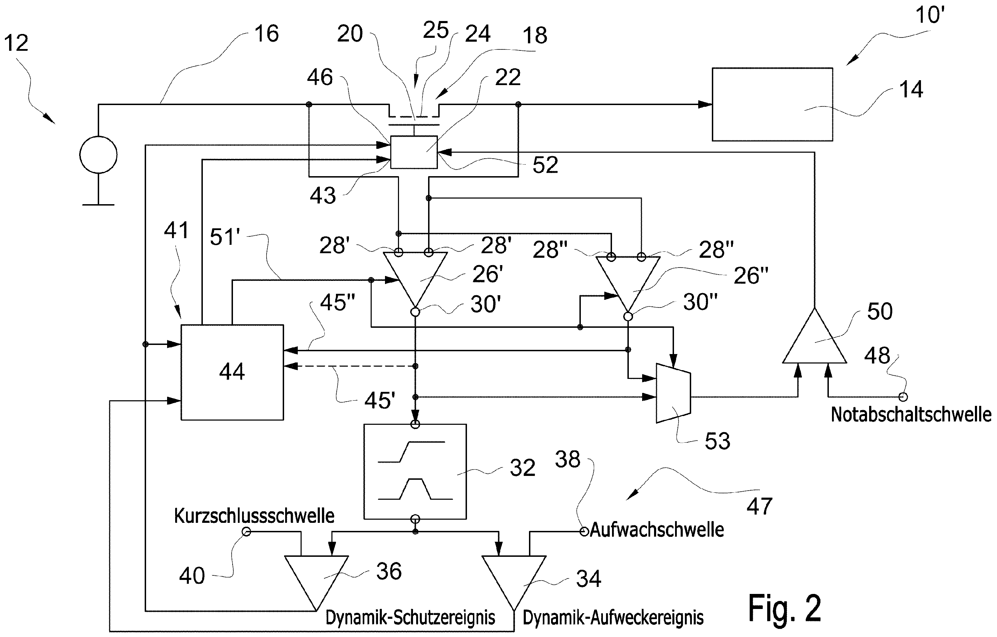

In Fig. 2 ist ein zweites Ausführungsbeispiel der Sicherheitsabschaltvorrichtung 10' gezeigt. Sofern die in Fig. 2 gezeigten Komponenten funktionsgleich bzw. identisch zu denjenigen der Blockschaltbilddarstellung gemäß Fig. 1 sind, sind sie in Fig. 2 mit den gleichen Bezugszeichen wie in Fig. 1 versehen.

Der Unterschied der beiden Konzepte der Sicherheitsabschaltvorrichtung 10, 10' der Fign. 1 und 2 besteht darin, dass in dem Blockschaltbild der Fig. 2 zwei Spannungsverstärker 26', 26" eingesetzt werden, zwischen denen, von der Überwachungseinheit 44 gesteuert, umgeschaltet wird. Der Spannungsverstärker 26' beispielsweise wird eingesetzt, wenn die Stromüberwachung bei sich im Standby-Modus befindlicher Überwachungseinheit 44 erfolgt, wie es z.B. bei im Ruhe- bzw. Standby-Betriebszustand befindlichem Verbraucher 14 der Fall ist, während der Spannungsverstärker 26" für die Stromüberwachung bei sich im Überwachungsmodus befindlicher Überwachungseinheit 44, wie z.B.im Aktivzustand des Verbrauchers 14 eingesetzt wird. Beides wird von der Überwachungseinheit 44 über die Selekt-Steuerleitung 51' gesteuert. Die Ausgänge 30', 30" der beiden Spannungsverstärker 26', 26" werden nun bedarfsweise mit dem Notabschaltkomparator 50 verbunden. Hierzu dient beispielsweise eine Multiplexschaltung 53, die ebenfalls über die Selekt-Steuerleitung 51' von der Überwachungseinheit 44 gesteuert wird. Der Ausgang des Spannungsverstärkers 26" ist mit der Überwachungseinheit 44 verbunden (siehe die Verbindungsleitung 45"), da die Überwachungseinheit 44 dann, wenn der Spannungsverstärker 26" bei sich im Überwachungsmodus befindlicher Überwachungseinheit 44 die Größe des Ausgangssignals des Spannungsverstärkers 26" für eine potentielle Sicherheitsabschaltung auswertet. Auch zwischen dem Ausgang des Spannungsverstärkers 26' und der Überwachungseinheit 44 kann eine elektrische Verbindung vorgesehen sein (in Fig. 2 durch gestrichelte Linie 45' angedeutet).

Mit der Signalleitung 54 ist in den Figuren angedeutet, dass von einer übergeordneten Systemebene (nicht dargestellt) an die Überwachungseinheit 44 ein Signal anlegbar ist, dass z.B. nach einem (aus welchen Gründen auch immer erfolgten) Ausschalten des elektronischen Schalters 18 dafür sorgt, dass der elektronische Schalter 18 wieder eingeschaltet wird. Vordefinierte, durch die Überwachungseinheit 44 zu veranlassende, Reaktionen können auch in einem mit den entsprechenden Informationen versorgten Konfigurationsspeichern in der Überwachungseinheit 44 oder auch außerhalb von dieser abgelegt sein. Ganz allgemein gesagt existieren für die Initiierung von Steuersignalen für die Überwachungseinheit, die zusätzlich zu den erfindungsgemäß vorgesehenen Ansteuerungen der Überwachungseinheit existieren, die verschiedensten Möglichkeiten. Sie können von einer übergeordneten Systemebene kommen (siehe z.B. die Steuer- bzw. Signalleitung 54), die das Ein- oder Ausschalten der Versorgungsleitung fordert. Das kann eine in der Überwachungseinheit 44 oder an anderer Stelle vorkonfigurierte Information sein, die bestimmt, welchen Zustand die Ausgänge der Überwachungseinheit 44 bei bestimmten Ereignissen z.B. nach Ablauf von vorgegebenen Zeitbedingungen oder bei Eintritt bestimmter Ereignisse annehmen sollen, die sich aus eigenen Messmitteln oder dem Monitoring oder einem Rücksetzen ergeben (z.B. bei Überlast im elektronischen Schalter 18, bei Unterspannung im System bzw. Bordnetz, bei Übertemperaturen z.B. des Verbrauchers oder des elektronischen Schalters oder anderer Bauteile der erfindungsgemäßen Vorrichtung, etc.). Über diese Vorkonfiguration als auch über die höhere Systemebene können selbstverständlich Schaltzustands-änderungen jederzeit angefordert oder geändert werden. Ebenso kann die Überwachungseinheit dann "aufgeweckt" werden, wenn sie z.B. wiederum von der übergeordneten Systemebene ein Signal erhält, das anzeigt, dass der Verbraucher von seinem Ruhe- bzw. Standby-Betriebszustand in seinen Aktivzustand wechselt, sofern die Vorrichtung das nicht über den für diesen Wechsel zu erwartenden "normalen" Stromanstieg festgestellt.

All das aber ist nicht wesentlich für die erfindungsgemäßen Vorrichtung, die sich mit der Auslösung der Aktivierung der Überwachungseinheit 44 befasst, wenn sich diese wegen des Standby- bzw. Ruhebetriebszustandes des Verbraucher 14 oder, wie oben beschrieben, aus anderen Gründen in ihrem Standby-Modus befindet.

Die Erfindung lässt sich gemäß vorteilhafter Ausgestaltungen und Varianten auch gemäß einem oder mehreren der nachfolgend genannten Merkmale vorteilhafterweise definieren:
1. Sicherheitsabschaltvorrichtung für einen elektrischen Verbraucher in einem Fahrzeug, wobei der Verbraucher in einem Aktivzustand und in mindestens einem weiteren Betriebszustand in einem Ruhezustand mit gegenüber dem Aktivzustand verminderter Stromaufnahme betreibbar ist, mit
   - einem elektronischen Schalter 18 mit einem Strompfad 24, der durch ein Einschaltsignal einschaltbar, d.h. leitend schaltbar, und durch ein Ausschaltsignal ausschaltbar, d.h. sperrend schaltbar, ist und der in einer direkt oder indirekt zu dem mindestens einen Verbraucher 14 des Fahrzeugs führenden Versorgungsleitung 16 angeordnet ist, über die der Verbraucher 14 mit den für den Betrieb in seinem Aktivzustand und für den Betrieb in seinem mindestens einen weiteren Betriebszustand oder in einem seiner weiteren Betriebszustände jeweils erforderlichen Ströme versorgbar ist,
   - einem in der Versorgungsleitung 16 angeordneten bei einem Stromfluss durch die Versorgungsleitung 16 einen Spannungsabfall erzeugenden Spannungserfassungsmittel 25,
   - mindestens einem Spannungsverstärker 26, 26', 26" mit zwei Eingängen 28, die beidseitig des Spannungserfassungsmittels 25 mit diesem oder mit der Versorgungsleitung 16 verbunden sind, und mit einem ein verstärktes Signal liefernden Ausgang 30, 30', 30",
   - einem Hoch- oder Bandpassfilter 32 zur Filterung des Signals am Ausgang 30, 30', 30" des Spannungsverstärkers 26, 26', 26" mit einem mit dem Ausgang 30, 30', 30' des Spannungsverstärkers 26, 26', 26" verbundenen Eingang 31 und mit einem das gefilterte Signal liefernden Ausgang 33,
   - einem mit dem Ausgang 33 des Hoch- oder Bandpassfilters 32 verbundenen ersten Komparator 34 zum Vergleichen der Größe des Ausgangssignals des Hoch- oder Bandpassfilters 32 mit einem ersten Schwellwert 38 und/oder mit einem ersten Spannungsbereich,
   - wobei der erste Komparator 34 ein erstes Aktivierungssignal 42 ausgibt, wenn das Ausgangssignal des Hoch- oder Bandpassfilters 32 größer als der erste Schwellwert 38 oder gleich dem ersten Schwellwert 38 ist und/oder den ersten Spannungsbereich unter- oder überschreitet,
   - einer das erste Aktivierungssignal 42 des ersten Komparators 34 empfangenden Überwachungseinheit 44, die immer dann, wenn sich der mindestens eine Verbraucher 14 in seinem Aktivzustand oder in seinem mindestens einen weiteren Betriebszustand oder in einem seiner weiteren Betriebszustände befindet, das Einschaltsignal für den elektronischen Schalter 18 zur Versorgung des mindestens einen Verbrauchers 14 mit Strom und für eine Sicherheitsabschaltung des mindestens einen Verbrauchers 14 das Ausschaltsignal für den elektronischen Schalter 18 erzeugt,
   - wobei die Überwachungseinheit 44 umschaltbare Schaltungskomponenten aufweist, die wahlweise aktivierbar oder deaktivierbar sind, wie z.B. eine Logikschaltung, einen ADC für eine Spannungsabfallmessung mit z.B. Bestimmung der thermischen Belastung der Versorgungsleitung und/oder des mindestens einen Verbrauchers auf Grund einer erhöhten Stromaufnahme und/oder eine Temperaturkompensationsschaltung und/oder eine Spannungsversorgungs- und/oder Spannungsregelschaltung und/oder Komparatoren mit Referenzspannungserzeugungsschaltungen,

   - wobei die Überwachungseinheit 44 dann, wenn ihre umschaltbaren Schaltungskomponenten deaktiviert sind, eine geringere elektrische Energie benötigt als in dem Fall, in dem ihre umschaltbaren Schaltungskomponenten aktiviert sind, und
   - wobei die umschaltbaren Schaltungskomponenten der Überwachungseinheit 44 dann, wenn sie deaktiviert sind, bei Empfang des ersten Aktivierungssignals 42 aktivierbar sind.
2. Sicherheitsabschaltvorrichtung nach Ziffer 1, gekennzeichnet durch einen mit dem Ausgang 30, 30', 30" des mindestens einen Spannungsverstärkers 26, 26', 26" verbundenen Notabschaltkomparator 50 zum Vergleichen der Größe des Signals am Ausgang 30, 30', 30" des mindestens einen Spannungsverstärkers 26, 26', 26" mit einem Notabschaltschwellwert 48, wobei der Notabschaltkomparator 50 ein Ausschaltsignal 52 für den elektronischen Schalter 18 erzeugt, wenn die Größe des Signals am Ausgang 30, 30', 30" des mindestens einen Spannungsverstärkers 26, 26', 26" den Notabschaltschwellwert 48 erreicht oder überschreitet.
3. Sicherheitsabschaltvorrichtung nach Ziffern 1 oder 2, wobei die Überwachungseinheit 44 mit dem Ausgang 30, 30', 30" des mindestens einen Spannungsverstärkers 26, 26', 26" verbunden ist und dann, wenn ihre umschaltbaren Schaltungskomponenten aktiviert sind, das Signal am Ausgang 30, 30', 30" des mindestens einen Spannungsverstärkers 26, 26', 26" hinsichtlich der wahlweisen Erzeugung des Einschaltsignals und des Ausschaltsignals für den elektronischen Schalter 18 bewertet.
4. Sicherheitsabschaltvorrichtung nach einer der Ziffern 1 bis 3, wobei der Ausgang 33 des Hoch- oder Bandpassfilters 32 mit einem zweiten Komparator 36 zum Vergleichen der Größe des Ausgangssignals des Hoch- oder Bandpassfilters 32 mit einem gegenüber dem ersten Schwellwert 38 größeren zweiten Schwellwert 40 verbunden ist, wobei der zweite Komparator 36 ein zweites Aktivierungssignal 46 ausgibt, wenn das Signal am Ausgang 33 des Hoch- oder Bandpassfilters 32 größer als der zweite Schwellwert 40 oder gleich dem zweiten Schwellwert 40 ist, wobei das zweite Aktivierungssignal 46 der Überwachungseinheit 44 zur Aktivierung ihrer umschaltbaren Schaltungskomponenten zwecks weiterer Be- und Verarbeitung zur eventuellen Umsetzung in ein Ausschaltsignal 43 für den elektronischen Schalter 18 zuführbar und/oder als Ausschaltsignal 46 für den elektronischen Schalter 18 ausgebildet ist.
5. Sicherheitsabschaltvorrichtung nach einer der Ziffern 1 bis 4, wobei ein einziger Spannungsverstärker 26 vorgesehen ist, der zwischen einem Betrieb mit höherem elektrischem Energiebedarf und einem Betrieb mit niedrigerem elektrischem Energiebedarf umschaltbar ist, und dass der Spannungsverstärker 26 bei deaktivierten Schaltungskomponenten der Überwachungseinheit 44 weniger Energie benötigt als bei aktivierten Schaltungskomponenten der Überwachungseinheit 44 und von der Überwachungseinheit 44 gesteuert umschaltbar ist.
6. Sicherheitsabschaltvorrichtung nach einer der Ziffern 1 bis 4, wobei ein erster Spannungsverstärker 26' und ein zweiter Spannungsverstärker 26" vorgesehen sind, von denen der erste Spannungsverstärker 26' bei deaktivierten Schaltungskomponenten der Überwachungseinheit 44 betreibbar und der zweite Spannungsverstärker 26" bei aktivierten Schaltungskomponenten der Überwachungseinheit 44 betreibbar ist, und dass das Hoch-oder Bandpassfilter 32 mit dem Ausgang 30 des ersten Spannungsverstärkers 26' verbunden ist.
7. Sicherheitsabschaltvorrichtung nach Ziffer 6 und Ziffer 2 oder Ziffer 3 oder 4, sofern auf Ziffer 2 rückbezogen, wobei die Ausgänge 30', 30" beider Spannungsverstärker 26', 26" mit dem Notabschaltkomparator 50 verbunden sind oder dass von diesen Ausgängen 30', 30" jeweils einer mit dem Notabschaltkomparator 50 verbindbar ist.
8. Sicherheitsabschaltvorrichtung nach Ziffer 6 und Ziffer 3 oder Ziffer 4, sofern auf Ziffer 3 rückbezogen, wobei die Überwachungseinheit 44 mit dem Ausgang 30" des zweiten Spannungsverstärkers 26" verbunden ist.
9. Sicherheitsabschaltvorrichtung nach einer der Ziffern 1 bis 8, wobei das Spannungserfassungsmittel 25 ein Shunt-Widerstand ist oder dass der Strompfad 24 des elektronischen Schalters 18 als Spannungserfassungsmittel 25 dient.
10. Verfahren zur Sicherheitsabschaltung eines elektrischen Verbrauchers in einem Fahrzeug, der direkt oder indirekt an einen mit einem elektronischen Schalter versehene Versorgungsleitung angeschlossen ist, wobei bei dem Verfahren
   - durch eine Hauptüberwachungseinheit 41, deren Betrieb von einem Überwachungsmodus auf einen Standby-Modus und umgekehrt umschaltbar ist, in ihrem Überwachungsmodus die Stromaufnahme des Verbrauchers 14 hinsichtlich einer Sicherheitsabschaltschwelle überwacht wird, die, wenn sie erreicht oder überschritten wird, zur Erzeugung eines Ausschaltsignals 43 zum Ausschalten des elektronischen Schalters 18 durch die Hauptüberwachungseinheit 41 führt,
   - die Hauptüberwachungseinheit 41 von dem Standby-Modus in den Überwachungsmodus umgeschaltet wird, wenn die Amplitude der dynamischen Veränderungen der Stromaufnahme des Verbrauchers 14 einen ersten Schwellwert 38 erreicht oder überschreitet und/oder einen ersten Spannungsbereich unter- oder überschreitet, und
   - die Stromaufnahme des Verbrauchers 14 in dem Standby-Modus der Hauptüberwachungseinheit 41 von einer Hilfsüberwachungseinheit 47 hinsichtlich der Amplitude einer potentiellen dynamischen Veränderung überwacht wird und die beim Erreichen oder Überschreiten des ersten Schwellwerts und/oder bei Unter- oder Überschreitung des ersten Spannungsbereichs die Umschaltung der Hauptüberwachungseinheit 41 von dem Standby-Modus in den Überwachungsmodus auslöst.
11. Verfahren nach Ziffer 10, wobei bei sich im Standby-Modus befindlicher Hauptüberwachungseinheit 41 ein Ausschaltsignal zum Ausschalten des elektronischen Schalters 18 erzeugt wird, wenn die Amplitude der dynamischen Veränderungen der Stromaufnahme des Verbrauchers 14 einen zweiten Schwellwert 40 erreicht oder überschreitet, der größer ist als der erste Schwellwert 38.
12. Verfahren nach Ziffer 10 oder 11, wobei bei sich im Standby-Modus befindlicher Hauptüberwachungseinheit 41 die Größe des Signals eines in der Versorgungsleitung 16 angeordneten Spannungserfassungsmittels 25 mit einem Notabschaltschwellwert 48 verglichen wird, bei dessen Erreichen oder Überschreiten ein Ausschaltsignal 52 zum Ausschalten des elektronischen Schalters 18 erzeugt wird.

Weitere Aspekte der Erfindung:
1. Sicherheitsabschaltvorrichtung für einen elektrischen Verbraucher in einem Fahrzeug, wobei der Verbraucher in einem Aktivzustand und in mindestens einem weiteren Betriebszustand mit gegenüber dem Aktivzustand verminderter Stromaufnahme, wie z.B. in einem Standby- oder Ruhezustand, betreibbar ist, mit
   - einem einen Strompfad (24) aufweisenden elektronischen Schalter (18) in einer direkt oder indirekt zu dem mindestens einen Verbraucher (14) des Fahrzeugs führenden Versorgungsleitung (16) angeordnet ist, über die der Verbraucher (14) mit den für den Betrieb in seinem Aktivzustand und für den Betrieb in seinem mindestens einen weiteren Betriebszustand oder in einem seiner weiteren Betriebszustände jeweils erforderlichen Ströme und Spannungen versorgbar ist,
   - einer Treiberschaltung (22) zur Ansteuerung des elektronischen Schalters (18), wobei an die Treiberschaltung (22) entweder ein Einschaltsignal zum Einschalten des elektronischen Schalters (18) und damit zum Leitendschalten seines Strompfads (24) oder ein Ausschaltsignal zum Ausschalten des elektronischen Schalters (18) und damit zum Sperrendschalten seines Strompfads (24) anlegbar ist,
   - einem zur Anordnung in der Versorgungsleitung (16) vorgesehenen und bei einem Stromfluss durch die Versorgungsleitung (16) einen Spannungsabfall erzeugenden Spannungserfassungsmittel (25),
   - mindestens einem Spannungsverstärker (26, 26', 26") mit zwei Eingängen (28), die beidseitig des Spannungserfassungsmittels (25) mit diesem oder mit der Versorgungsleitung (16) verbunden sind, und mit einem ein verstärktes Signal liefernden Ausgang (30, 30', 30"),
   - einem Hoch- oder Bandpassfilter (32) zur Filterung des Signals am Ausgang (30, 30', 30") des Spannungsverstärkers (26, 26', 26") mit einem mit dem Ausgang (30, 30', 30") des Spannungsverstärkers (26, 26', 26") verbundenen Eingang (31) und mit einem das gefilterte Signal liefernden Ausgang (33),
   - einem mit dem Ausgang (33) des Hoch- oder Bandpassfilters (32) verbundenen, zwei Eingänge und einen Ausgang aufweisenden, ersten Komparator (34) zum Vergleichen der Größe des Ausgangssignals des Hoch- oder Bandpassfilters (32) mit einem ersten Schwellwert (38) und/oder mit einem ersten Spannungsbereich,
   - wobei der erste Komparator (34) an seinem Ausgang ein erstes Aktivierungssignal (42) ausgibt, wenn das Ausgangssignal des Hoch- oder Bandpassfilters (32) größer als der erste Schwellwert (38) oder gleich dem ersten Schwellwert (38) ist und/oder den ersten Spannungsbereich unter- oder überschreitet,
   - einer mit dem Ausgang des ersten Komparators (34) verbundenen Überwachungseinheit (44), die immer dann, wenn sich der mindestens eine Verbraucher (14) in seinem Aktivzustand oder in seinem mindestens einen weiteren Betriebszustand oder in einem seiner weiteren Betriebszustände befindet, für die Treiberschaltung (22) das Einschaltsignal für den elektronischen Schalter (18) zur Versorgung des mindestens einen Verbrauchers (14) mit Strom und zwecks einer potenziellen Sicherheitsabschaltung des mindestens einen Verbrauchers (14) für die Treiberschaltung (22) das Ausschaltsignal für den elektronischen Schalter (18) ausgibt ,
   - wobei die Überwachungseinheit (44) umschaltbare Schaltungskomponenten aufweist, die wahlweise aktivierbar oder deaktivierbar, d.h. in einen Ausschalt- oder einen Standby-Modus überführbar sind, wie z.B. eine Logikschaltung, einen ADC für eine Spannungsabfallmessung mit z.B. Bestimmung der thermischen Belastung der Versorgungsleitung und/oder des mindestens einen Verbrauchers auf Grund einer erhöhten Stromaufnahme und/oder eine Temperaturkompensationsschaltung und/oder eine Spannungsversorgungs- und/oder Spannungsregelschaltung und/oder Komparatoren mit Referenzspannungserzeugungsschaltungen,
   - wobei die Überwachungseinheit (44) dann, wenn ihre umschaltbaren Schaltungskomponenten deaktiviert sind, eine geringere elektrische Energie benötigt als in dem Fall, in dem ihre umschaltbaren Schaltungskomponenten aktiviert sind, und
   - wobei die umschaltbaren Schaltungskomponenten der Überwachungseinheit (44) dann, wenn sie deaktiviert sind, bei Empfang des am Ausgang des ersten Komparators (34) anstehenden ersten Aktivierungssignals (42) aktivierbar sind.
2. Sicherheitsabschaltvorrichtung nach 1, gekennzeichnet durch einen mit dem Ausgang (30, 30', 30") des mindestens einen Spannungsverstärkers (26, 26', 26") verbundenen, zwei Eingänge und einen Ausgang aufweisenden Notabschaltkomparator (50) zum Vergleichen der Größe des Signals am Ausgang (30, 30', 30") des mindestens einen Spannungsverstärkers (26, 26', 26") mit einem Notabschaltschwellwert (48), wobei der Notabschaltkomparator (50) an seinem Ausgang für die Treiberschaltung (22) ein Ausschaltsignal (52) für den elektronischen Schalter (18) ausgibt, wenn die Größe des Signals am Ausgang (30, 30', 30") des mindestens einen Spannungsverstärkers (26, 26', 26") den Notabschaltschwellwert (48) erreicht oder überschreitet.
3. Sicherheitsabschaltvorrichtung nach 1 oder 2, dadurch gekennzeichnet, dass die Überwachungseinheit (44) mit dem Ausgang (30, 30', 30") des mindestens einen Spannungsverstärkers (26, 26', 26") verbunden ist und dann, wenn ihre umschaltbaren Schaltungskomponenten aktiviert sind, das Signal am Ausgang (30, 30', 30") des mindestens einen Spannungsverstärkers (26, 26', 26") hinsichtlich der wahlweisen Erzeugung des Einschaltsignals und des Ausschaltsignals für den elektronischen Schalter (18) bewertet.
4. Sicherheitsabschaltvorrichtung nach 1 bis 3, dadurch gekennzeichnet, dass der Ausgang (33) des Hoch- oder Bandpassfilters (32) mit einem zweiten Komparator (36) zum Vergleichen der Größe des Ausgangssignals des Hoch- oder Bandpassfilters (32) mit einem gegenüber dem ersten Schwellwert (38) größeren zweiten Schwellwert (40) verbunden ist, wobei der zweite Komparator (36) ein zweites Aktivierungssignal (46) ausgibt, wenn das Signal am Ausgang (33) des Hoch- oder Bandpassfilters (32) größer als der zweite Schwellwert (40) oder gleich dem zweiten Schwellwert (40) ist, wobei das zweite Aktivierungssignal (46) der Überwachungseinheit (44) zur Aktivierung ihrer umschaltbaren Schaltungskomponenten zwecks weiterer Be- und Verarbeitung zur eventuellen Umsetzung in ein Ausschaltsignal (43) für den elektronischen Schalter (18) zuführbar und/oder als Ausschaltsignal (46) für den elektronischen Schalter (18) ausgebildet ist.
5. Sicherheitsabschaltvorrichtung nach 1 bis 4, dadurch gekennzeichnet, dass ein einziger Spannungsverstärker (26) vorgesehen ist, der zwischen einem Betrieb mit höherem elektrischem Energiebedarf und einem Betrieb mit niedrigerem elektrischem Energiebedarf umschaltbar ist, und dass der Spannungsverstärker (26) bei deaktivierten Schaltungskomponenten der Überwachungseinheit (44) weniger Energie benötigt als bei aktivierten Schaltungskomponenten der Überwachungseinheit (44) und von der Überwachungseinheit (44) gesteuert umschaltbar ist.
6. Sicherheitsabschaltvorrichtung nach 1 bis 5, gekennzeichnet durch einen einzigen Spannungsverstärker (26), wobei entweder der Spannungsverstärker (26) einen z.B. durch die Überwachungseinheit (44) gesteuerten, veränderbaren Verstärkungsfaktor aufweist, der bei deaktivierten Schaltungskomponenten der Überwachungseinheit (44) größer ist als bei aktivierten Schaltungskomponenten der Überwachungseinheit (44), oder das Hoch- oder Bandpassfilter (32) einen bei deaktivierten Schaltungskomponenten der Überwachungseinheit (44) zuschaltbaren Spannungsverstärker zur Ausgabe eines gegenüber der Verstärkung durch den Spannungsverstärker (26) noch weiter und damit höher verstärkten Ausgangssignals aufweist.
7. Sicherheitsabschaltvorrichtung nach 1 bis 4, dadurch gekennzeichnet, dass ein erster Spannungsverstärker (26') und ein zweiter Spannungsverstärker (26") vorgesehen sind, von denen der erste Spannungsverstärker (26') bei deaktivierten Schaltungskomponenten der Überwachungseinheit (44) betreibbar und der zweite Spannungsverstärker (26") bei aktivierten Schaltungskomponenten der Überwachungseinheit (44) betreibbar ist, und dass das Hoch- oder Bandpassfilter (32) mit dem Ausgang (30) des ersten Spannungsverstärkers (26') verbunden ist.
8. Sicherheitsabschaltvorrichtung nach 1 bis 4, dadurch gekennzeichnet, dass ein erster Spannungsverstärker (26') mit einem ersten Verstärkungsfaktor und ein zweiter Spannungsverstärker (26") mit einem gegenüber dem ersten Verstärkungsfaktor kleineren zweiten Verstärkungsfaktor vorgesehen sind, von denen der erste Spannungsverstärker (26') bei deaktivierten Schaltungskomponenten der Überwachungseinheit (44) betreibbar und der zweite Spannungsverstärker (26") bei aktivierten Schaltungskomponenten der Überwachungseinheit (44) betreibbar ist, und dass das Hoch- oder Bandpassfilter (32) mit dem Ausgang (30) des ersten Spannungsverstärkers (26') verbunden ist.
9. Sicherheitsabschaltvorrichtung nach 7 oder 8 und 2 oder 3 oder 4, sofern auf 2 rückbezogen, dadurch gekennzeichnet, dass die Ausgänge (30', 30") beider Spannungsverstärker (26', 26") mit einem der Eingänge des Notabschaltkomparators (50) verbunden sind oder dass von den Ausgängen (30', 30") dieser beiden Spannungsverstärker (26', 26") wahlweise einer mit einem der Eingänge des Notabschaltkomparators (50) verbindbar ist.
10. Sicherheitsabschaltvorrichtung nach 7 oder 8 und 3 oder 4, sofern auf 3 rückbezogen, dadurch gekennzeichnet, dass die Überwachungseinheit (44) mit dem Ausgang (30") des zweiten Spannungsverstärkers (26") verbunden ist.
11. Sicherheitsabschaltvorrichtung nach 1 bis 10, dadurch gekennzeichnet, dass das Spannungserfassungsmittel (25) ein Shunt-Widerstand ist oder dass der Strompfad (24) des elektronischen Schalters (18) als Spannungserfassungsmittel (25) dient.
12. Verfahren zur Sicherheitsabschaltung eines elektrischen Verbrauchers in einem Fahrzeug, der direkt oder indirekt an einen mit einem elektronischen Schalter versehene Versorgungsleitung angeschlossen ist, wobei bei dem Verfahren
   - durch eine Hauptüberwachungseinheit (41), deren Betrieb von einem Überwachungsmodus auf einen Standby-Modus und umgekehrt umschaltbar ist, die Stromaufnahme des Verbrauchers (14) in ihrem Überwachungsmodus hinsichtlich der Über- bzw. Unterschreitung einer Sicherheitsabschaltschwelle überwacht wird, die, wenn sie erreicht oder überschritten wird, zur Erzeugung eines Ausschaltsignals (43) zum Ausschalten des elektronischen Schalters (18) durch die Hauptüberwachungseinheit (41) führt,
   - die Hauptüberwachungseinheit (41) von dem Standby-Modus in den Überwachungsmodus umgeschaltet wird, wenn die Amplitude der dynamischen Veränderungen der Stromaufnahme des Verbrauchers (14) einen ersten Schwellwert (38) erreicht oder überschreitet und/oder einen ersten Wertebereich und/oder einen zum ersten Schwellwert (38) proportionalen Spannungswert oder einem zum ersten Wertebereicht proportionalen Spannungsbereich unter-oder überschreitet, und
   - die Stromaufnahme des Verbrauchers (14) in dem Standby-Modus der Hauptüberwachungseinheit (41) von einer Hilfsüberwachungseinheit (47) hinsichtlich einer potentiellen dynamischen Veränderung der Amplitude überwacht wird und die beim Erreichen oder Überschreiten des ersten Schwellwerts und/oder bei Unter- oder Überschreitung des ersten Wertebereichs und/oder des zum ersten Schwellwert (38) proportionalen Spannungswerts oder des zum ersten Wertebereich proportionalen Spannungsbereichs die Umschaltung der Hauptüberwachungseinheit (41) von dem Standby-Modus in den Überwachungsmodus auslöst.
13. Verfahren nach 12, dadurch gekennzeichnet, dass bei sich im Standby-Modus befindlicher Hauptüberwachungseinheit (41) ein Ausschaltsignal zum Ausschalten des elektronischen Schalters (18) erzeugt wird, wenn die Amplitude der dynamischen Veränderungen der Stromaufnahme des Verbrauchers (14) einen zweiten Schwellwert (40) erreicht oder überschreitet, der größer ist als der erste Schwellwert (38).
14. Verfahren nach 12 oder 13, dadurch gekennzeichnet, dass bei sich im Standby-Modus befindlicher Hauptüberwachungseinheit (41) die Größe des Signals eines in der Versorgungsleitung (16) angeordneten Spannungserfassungsmittels (25) mit einem Notabschaltschwellwert (48) verglichen wird, bei dessen Erreichen oder Überschreiten ein Ausschaltsignal (52) zum Ausschalten des elektronischen Schalters (18) erzeugt wird.

### BEZUGSZEICHENLISTE

- 10: Sicherheitsabschaltvorrichtung
- 10': Sicherheitsabschaltvorrichtung
- 12: Energiequelle (z.B. Bordnetz des Fahrzeugs)
- 14: elektrischer Verbraucher
- 16: Versorgungsleitung
- 18: elektronischer Schalter
- 20: MOS-Transistors
- 22: Treiber
- 24: Strompfad
- 25: Spannungserfassungsmittel
- 26: Spannungsverstärker
- 26': erster Spannungsverstärker
- 26": zweiter Spannungsverstärker
- 28: Eingänge des Spannungsverstärkers
- 30: Ausgang des Spannungsverstärkers
- 30': Ausgang des Spannungsverstärkers
- 30": Ausgang des Spannungsverstärkers
- 31: Eingang des Hoch- und Bandpassfilters
- 32: Hoch- oder Bandpassfilter
- 33: Ausgang des Hoch- oder Bandpassfilters
- 34: erster Komparator
- 36: zweiter Komparator
- 38: Aufwachschwelle
- 40: Kurzschlussschwelle
- 41: Hauptüberwachungseinheit
- 42: Aktivierungssignal
- 43: Abschaltsignal
- 44: Überwachungseinheit
- 45: Verbindungsleitung von dem Spannungsverstärker zur Überwachungseinheit
- 45': Verbindungsleitung von dem Spannungsverstärker zur Überwachungseinheit
- 46: Notausschaltsignal
- 47: Hilfsüberwachungseinheit
- 48: Notabschaltschwelle
- 50: Notabschaltkomparator
- 51: Selekt-Steuerleitung
- 51': Selekt-Steuerleitung
- 52: Notausschaltsignal
- 53: Multiplexschaltung
- 54: Steuer- bzw. Signalleitung

## Patentansprüche

1. Verfahren zur Sicherheitsabschaltung eines elektrischen Verbrauchers in einem Fahrzeug, der direkt oder indirekt an einen mit einem elektronischen Schalter versehene Versorgungsleitung angeschlossen ist, wobei bei dem Verfahren
- durch eine Hauptüberwachungseinheit (41), deren Betrieb von einem Überwachungsmodus auf einen Standby-Modus und umgekehrt umschaltbar ist, die Stromaufnahme des Verbrauchers (14) in ihrem Überwachungsmodus hinsichtlich der Über- bzw. Unterschreitung einer Sicherheitsabschaltschwelle überwacht wird, die, wenn sie erreicht oder überschritten wird, zur Erzeugung eines Ausschaltsignals (43) zum Ausschalten des elektronischen Schalters (18) durch die Hauptüberwachungseinheit (41) führt,
- die Hauptüberwachungseinheit (41) von dem Standby-Modus in den Überwachungsmodus umgeschaltet wird, wenn die Amplitude der dynamischen Veränderungen der Stromaufnahme des Verbrauchers (14) einen ersten Schwellwert (38) erreicht oder überschreitet und/oder einen ersten Wertebereich und/oder einen zum ersten Schwellwert (38) proportionalen Spannungswert oder einem zum ersten Wertebereicht proportionalen Spannungsbereich unter- oder überschreitet, und
- die Stromaufnahme des Verbrauchers (14) in dem Standby-Modus der Hauptüberwachungseinheit (41) von einer Hilfsüberwachungseinheit (47) hinsichtlich einer potentiellen dynamischen Veränderung der Amplitude überwacht wird und die beim Erreichen oder Überschreiten des ersten Schwellwerts und/oder bei Unter- oder Überschreitung des ersten Wertebereichs und/oder des zum ersten Schwellwert (38) proportionalen Spannungswerts oder des zum ersten Wertebereich proportionalen Spannungsbereichs die Umschaltung der Hauptüberwachungseinheit (41) von dem Standby-Modus in den Überwachungsmodus auslöst.

2. Verfahren nach Anspruch 1, **dadurch gekennzeichnet, dass** bei sich im Standby-Modus befindlicher Hauptüberwachungseinheit (41) ein Ausschaltsignal zum Ausschalten des elektronischen Schalters (18) erzeugt wird, wenn die Amplitude der dynamischen Veränderungen der Stromaufnahme des Verbrauchers (14) einen zweiten Schwellwert (40) erreicht oder überschreitet, der größer ist als der erste Schwellwert (38).

3. Verfahren nach Anspruch 1 oder 2, **dadurch gekennzeichnet, dass** bei sich im Standby-Modus befindlicher Hauptüberwachungseinheit (41) die Größe des Signals eines in der Versorgungsleitung (16) angeordneten Spannungserfassungsmittels (25) mit einem Notabschaltschwellwert (48) verglichen wird, bei dessen Erreichen oder Überschreiten ein Ausschaltsignal (52) zum Ausschalten des elektronischen Schalters (18) erzeugt wird.
